(19) **Europäisches Patentamt**
**European Patent Office**
**Office européen des brevets**

(11) **EP 2 803 716 B1**

(12) **EUROPEAN PATENT SPECIFICATION**

(45) Date of publication and mention
of the grant of the patent:
**03.02.2016 Bulletin 2016/05**

(51) Int Cl.:
***H01L 33/50*** *(2010.01)*   ***C09K 11/64*** *(2006.01)*

(21) Application number: **14155102.8**

(22) Date of filing: **13.02.2014**

(54) **SIALON PHOSPHOR**

**SIALON LEUCHTSTOFF**

**SIALON LUMINOPHORE**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **15.05.2013   JP 2013103464**

(43) Date of publication of application:
**19.11.2014   Bulletin 2014/47**

(73) Proprietor: **Kabushiki Kaisha Toshiba
Tokyo 105-8001 (JP)**

(72) Inventors:
  • **Okada, Aoi
    Tokyo 105-8001 (JP)**
  • **Kato, Masahiro
    Tokyo 105-8001 (JP)**
  • **Albessard, Keiko
    Tokyo 105-8001 (JP)**
  • **Fukuda, Yumi
    Tokyo 105-8001 (JP)**
  • **Mitsuishi, Iwao
    Tokyo 105-8001 (JP)**
  • **Hattori, Yasushi
    Tokyo 105-8001 (JP)**

(74) Representative: **Granleese, Rhian Jane
Marks & Clerk LLP
90 Long Acre
London WC2E 9RA (GB)**

(56) References cited:
**US-A1- 2010 133 563     US-A1- 2010 164 367
US-A1- 2012 104 317**

EP 2 803 716 B1

**Description**

FIELD

Embodiments described herein generally relate to a phosphor and a light-emitting device.

BACKGROUND

A white light-emitting device is formed, for example, combining a phosphor which emits red light by excitation with blue light, a phosphor which emits green light by excitation with blue light, and a blue LED. When a phosphor which emits yellow light by excitation with blue light is used, a white light-emitting device can be formed using fewer kinds of phosphors. As such a yellow-emitting phosphor, for example, an Eu-activated orthosilicate phosphor is known.
Demands for a high quantum efficiency of the yellow-emitting phosphor for obtaining a white LED illumination with a high efficiency have been increased.
US 2012/104317 A1 discloses a phosphor of formula SrAl1.25Si3.75O0.25N6.75:Ce which has been prepared using B2O3 and BN fluxes (Examples 18, 31) and a light emitting device using these phosphors (claims 23-26).

BRIEF DESCRIPTION OF THE DRAWINGS

FIGS. 1A, 1B and 1C are views showing crystal structures of $Sr_2Al_3Si_7ON_{13}$;
FIG. 2 is a schematic view showing a structure of a light-emitting device according to one embodiment;
FIG. 3 is a schematic view showing a structure of a light-emitting device according to another embodiment;
FIG. 4 is a view showing emission spectra of the phosphor of Example 1;
FIG. 5 is an XRD pattern of a phosphor of Example 4;
FIG. 6 is a JCPDS card (No. 01-077-9609); and
FIG. 7 is a view showing a relationship between a boron concentration in a phosphor and a quantum efficiency.

DETAILED DESCRIPTION

In an embodiment a phosphor is provided as recited in claim 1.
Embodiments are specifically explained below.
A phosphor according to one embodiment shows an luminescence peak within a wavelength range of 500 to 600 nm when it is excited with light having an emission peak within a wavelength range of 250 to 500 nm, and thus it is a phosphor capable of emitting light having a color range of yellowish-green to orange. As the material mainly emits yellow light, the phosphor of the present embodiment is hereinafter referred to as a "yellow-emitting phosphor." Such a phosphor includes a matrix having a crystal structure which is substantially the same as that of $Sr_2Si_3Al_7ON_{13}$, and this matrix can be activated with Ce. The yellow-emitting phosphor according to the present embodiment has a composition represented by the following Formula 1

$$(M_{1-x}Ce_x)2_yAl_zSi_{10-z}O_uN_wB_S \qquad \text{Formula 1}$$

wherein M is Sr and a part of Sr may be substituted by at least one selected from the group consisting of Ba, Ca and Mg; and x, y, z, u, w and s satisfy the following conditions:

$$0 < x \le 1, \ 0.8 \le y \le 1.1, \ 2 \le z \le 3.5, \ 1 < u \le 1$$

$$1.5 \le z - u, \ 13 \le u + w \le 15, \ \text{and} \ 0.02 \le s \le 0.14.$$

As shown in the Formula 1, at least a part of M is substituted by the luminescent center element Ce. M is Sr, and a part of Sr may be substituted by at least one selected from Ba, Ca and Mg. Generation of a heterophase is not promoted even if at least one selected from Ba, Ca and Mg is included so long as the content thereof is 15 at.% or less of the total amount of M, more preferably 10 at.% or less.
When at least 0.1 % by mole of M is substituted by Ce, a sufficient luminous efficiency can be obtained. All of M may be substituted by Ce (x = 1), but when x is 0.5 or less, reduction of external quantum efficiency (concentration quenching) can be inhibited to the utmost. The number x is, accordingly, preferably 0.001 to 0.5. As the luminescent center element Ce is included, the phosphor of the present embodiment emits light having a color range of yellowish-green to orange, i.e., emits light having a luminescence peak within the wavelength range of 500 to 600 nm, when it is excited with light having an emission peak within a wavelength range of 250 to 500 nm. Even if other elements, which are impurities, are unavoidably included, the desired properties are not impaired, so long as the content thereof is 15 at.% or less of Ce, more desirably 10 at.% or less. The impurities may include, for example, Tb, Eu, Mn, and the like.

When y is less than 0.8, the number of crystal defects is increased to lead to a reduced efficiency. On the other hand, when y is more than 1.1, an excess alkaline earth metal is deposited as a heterophase, and thus the luminescence property is degraded. The number y is preferably 0.85 to 1.06.

When z is less than 2, excess Si is deposited as a heterophase, and thus the luminescence property is reduced. On the other hand, when z is more than 3.5, excess Al is deposited as a heterophase, and thus the luminescence property is reduced. The number z is preferably 2.5 to 3.3.

When u is more than 1, the efficiency is reduced with the increase of the number of crystal defects. The number u is preferably 0.001 to 0.8.

When (z - u) is less than 1.5, the crystal structure of the present embodiment cannot be maintained. In some cases, the heterophase may be generated, and thus the effects of the present embodiment cannot be exhibited. In addition, when (u + w) is less than 13 or more than 15, the crystal structure of the present embodiment also cannot be maintained. In some cases, the heterophase may be generated, and thus the effects of the present embodiment cannot be exhibited. The number (z - u) is preferably 2 or more, and the number (u + w) is preferably 13.2 to 14.2.

When s is 0, a good quantum efficiency cannot be obtained. On the other hand, when s is 0.245 or more, the quantum efficiency is reduced. In order to obtain a better quantum efficiency, s is 0.02 or more and 0.14 or less.

The phosphor according to the present embodiment has all of the conditions described above, and thus it can emit yellow light with high efficiency when it is excited with light having emission peaks within a wavelength range of 250 to 500 nm.

It can be also said that the yellow-emitting phosphor of the present embodiment is a material based on the $Sr_2Al_3Si_7ON_{13}$ group crystals, in which Sr, Si, Al, O or N, which are elements forming the crystals, is substituted by another element, or another metal element such as Ce is solidified. Although the crystal structure is slightly changed by such a substitution, a large change of the positions of the atoms, such as breakage of a chemical bond between backbone atoms, rarely occurs. The position of the atom is provided by the crystal structure, the site occupied by the atom, and the coordinate thereof.

The effects of the present embodiment can be exhibited within a range in which the basic crystal structure of the yellow-emitting phosphor of the present embodiment is not changed. The phosphor according to the present embodiment may sometimes be different in a lattice constant and lengths of chemical bonds M-N and M-O (distances between near neighbor atoms) from a case of $Sr_2Al_3Si_7ON_{13}$. When the variation is within ±15% of the lattice constant of $Sr_2Al_3Si_7ON_{13}$ and is within ±15% of the chemical bond lengths (Sr-N and Sr-O) in $Sr_2Al_3Si_7ON_{13}$, then the crystal structure is defined as unchanged. The lattice constant can be obtained by an X-ray diffraction or a neutron beam diffraction, and the lengths of the chemical bonds M-N and M-O (distances between near neighbor atoms) can be calculated from an atomic coordinate.

The $Sr_2Al_3Si_7ON_{13}$ crystals are of the monoclinic system, especially the orthorhombic system, and have a lattice constant of a = 11.8 angstroms, b = 21.6 angstroms, and c = 5.01 angstroms. The crystals belong to a space group Pna 21 (the 33rd in a space group shown in a literature (International Tables for Crystallography, Volume A: Space-group symmetry, edited by T. Hahn, published by Springer (Netherlands) (publication date: 1983, the first edition))). The lengths of the chemical bonds in $Sr_2Al_3Si_7ON_{13}$ (Sr-N and Sr-O) can be calculated from the atomic coordinates shown in Table 1.

Table 1

|  | Site | Occupancy ratio | x | y | z |
|---|---|---|---|---|---|
| Sr1 | 4a | 1 | 0.2786 | 0.49060(11) | 0.5284(14) |
| Sr2 | 4a | 1 | 0.3552(3) | 0.69839(12) | 0.048(2) |
| Si/Al1 | 4a | 1 | 0.3582(9) | 0.2769(3) | 0.070(3) |
| Si/Al2 | 4a | 1 | 0.5782(9) | 0.7996(4) | 0.047(5) |
| Si/Al3 | 4a | 1 | 0.5563(8) | 0.4672(3) | 0.543(5) |
| Si/Al4 | 4a | 1 | 0.4724(8) | 0.6092(3) | 0.556(4) |

(continued)

| | Site | Occupancy ratio | x | y | z |
|---|---|---|---|---|---|
| Si/Al5 | 4a | 1 | 0.1910(7) | 0.6397(3) | 0.535(4) |
| Si/Al6 | 4a | 1 | 0.0061(8) | 0.5438(3) | 0.546(4) |
| Si/Al7 | 4a | 1 | 0.1625(9) | 0.5661(3) | 0.038(4) |
| Si/Al8 | 4a | 1 | 0.3937(8) | 0.3469(3) | 0.547(4) |
| Si/Al9 | 4a | 1 | 0.1552(18) | 0.3483(8) | 0.318(3) |
| Si/Al10 | 4a | 1 | 0.1525(14) | 0.3492(6) | 0.813(2) |
| O/N1 | 4a | 1 | 0.436(2) | 0.8164(10) | 0.061(11) |
| O/N2 | 4a | 1 | 0.699(2) | 0.4692(10) | 0.513(10) |
| O/N3 | 4a | 1 | 0.334(2) | 0.6355(10) | 0.511(9) |
| O/N4 | 4a | 1 | 0.213(2) | 0.2980(11) | 0.056(12) |
| O/N5 | 4a | 1 | 0.256(2) | 0.3750(10) | 0.563(9) |
| O/N6 | 4a | 1 | 0.894(2) | 0.6002(12) | 0.549(14) |
| O/N7 | 4a | 1 | 0.358(3) | 0.2062(12) | 0.893(6) |
| O/N8 | 4a | 1 | 0.508(2) | 0.4677(12) | 0.885(6) |
| O/N9 | 4a | 1 | 0.398(2) | 0.2727(12) | 0.392(6) |
| O/N10 | 4a | 1 | 0.430(3) | 0.3336(15) | 0.896(7) |
| O/N11 | 4a | 1 | 0.942(3) | 0.4814(15) | 0.371(8) |
| O/N12 | 4a | 1 | 0.662(2) | 0.8571(12) | 0.893(6) |
| O/N13 | 4a | 1 | 0.128(3) | 0.5743(15) | 0.381(7) |
| O/N14 | 4a | 1 | 0.495(3) | 0.3982(13) | 0.383(6) |

It is essential that the yellow-emitting phosphor of the present embodiment has the crystal structure described above. When the length of the chemical bond is changed beyond this range, the chemical bond is broken and forms another crystal, and thus the effects by the present invention cannot be obtained.

The yellow-emitting phosphor of the present embodiment is a material based on an inorganic compound having substantially the same crystal structure as that of $Sr_2Al_3Si_7ON_{13}$ in which a part of the forming atoms M are substituted by the luminescent center Ce, and the element composition is defined in a predetermined range. In this case, the preferable property of the high quantum efficiency is shown.

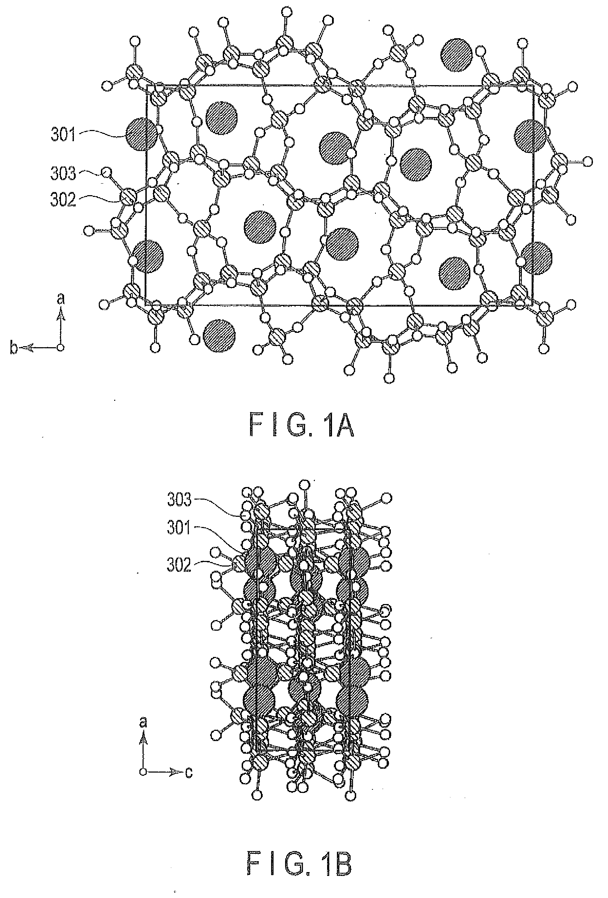

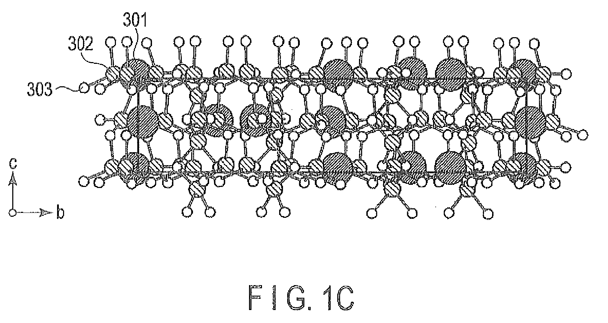

The crystal structures of $Sr_2Al_3Si_7ON_{13}$ are as shown in FIGs. 1A, 1B and 1C, based on the atomic coordinates shown in Table 1. FIG. 1A is a projection view in the c-axis direction, FIG. 1B is a projection view in the b-axis direction, and FIG. 1C is a projection view in the a-axis direction. In the views, 301 shows an atom Sr, and the atom is surrounded by an atom Si or Al 302, and an atom O or N 303. The crystals of $Sr_2Al_3Si_7ON_{13}$ can be identified by an XRD or neutron diffraction.

The yellow-emitting phosphor according to the present embodiment can be produced by mixing raw material powders including each element, and firing the mixture.

A raw material for M (M source) can be selected from nitrides and carbides of M. A raw material for Al (Al source) can be selected from nitrides, oxides and carbides of Al, and a raw material for Si (Si source) can be selected from nitrides, oxides and carbides of Si. A raw material for the luminescent center element Ce (Ce source) can be selected from chlorides, oxides and nitrides of Ce. A raw material for B (B source) can be selected from hydroxides of B, oxides of B, and the like.

Nitrogen can be provided from a nitride raw material or by firing in an atmosphere including nitrogen, and oxygen can be provided from an oxide raw material or an oxide coating film on a surface of a nitride raw material.

When the phosphor according to the present embodiment is produced, for example, $Sr_3N_2$, $CeCl_3$, $Si_3N_4$, AlN and $B(OH)_3$, which are source powders, are mixed in a preparation composition capable of providing a desired composition. $Sr_2N$ or SrN, or a mixture thereof may be used instead of $Sr_3N_2$. The sources may be mixed, for example, using a mortar in a glove box. The mixed powder is put in a crucible and it is fired in predetermined conditions, whereby the phosphor according to the present embodiment can be obtained. The material for the crucible is not particularly limited, and can be selected from boron nitride, silicon nitride, silicon carbide, carbon, aluminum nitride, sialon, aluminum oxide, molybdenum, tungsten, and the like.

It is preferable to fire the mixed powder in a pressure of atmospheric pressure or higher. When it is performed in a pressure of atmospheric pressure or higher, it is advantageously difficult to decompose the silicon nitride. In order to decompose the silicon nitride at a high temperature, the pressure is more preferably 5 atmospheres or higher, and the firing temperature is preferably within a range of 1500 to 2000°C. When the firing is performed in such conditions, a desired fired compact can be obtained without occurrence of disadvantages such as sublimation of the raw materials and products. The firing temperature is more preferably from 1800 to 2000°C.

In order to avoid the oxidation of AlN, it is desirable to fire it in a nitrogen atmosphere. Hydrogen may be contained in a content of up to about 50% in the atmosphere.

The phosphor of the present embodiment is obtained by the firing at the temperature described above for 1 to 20 hours. Alternatively, after the firing is performed at the temperature described above for 0.5 to 4 hours, the fired product may be taken out from the crucible and is cracked, and the firing may be performed again in the same conditions as above. When a series of steps of taken out, cracking and firing are repeated 0 to about 10 times, the advantages of crystal particles being slightly fused to each other and a powder having uniform composition and crystal structure being easily produced can be obtained.

After the firing, the resulting product may be subjected to a post-treatment such as washing if necessary, thereby obtaining the phosphor according to one embodiment. In the washing, for example, pure water, an acid, or the like may be used. As the acid, an inorganic acid such as sulfuric acid, nitric acid, hydrochloric acid or hydrofluoric acid, an organic acid such as formic acid, acetic acid or oxalic acid, or a mixed acid thereof may be used.

Before or after the washing with an acid, the resulting product may be subjected to a post-annealing treatment, if necessary. The post-annealing treatment may be performed, for example, in a reduction atmosphere including nitrogen and hydrogen. When such a post-annealing treatment is performed, the crystallizability and the luminous efficiency are improved.

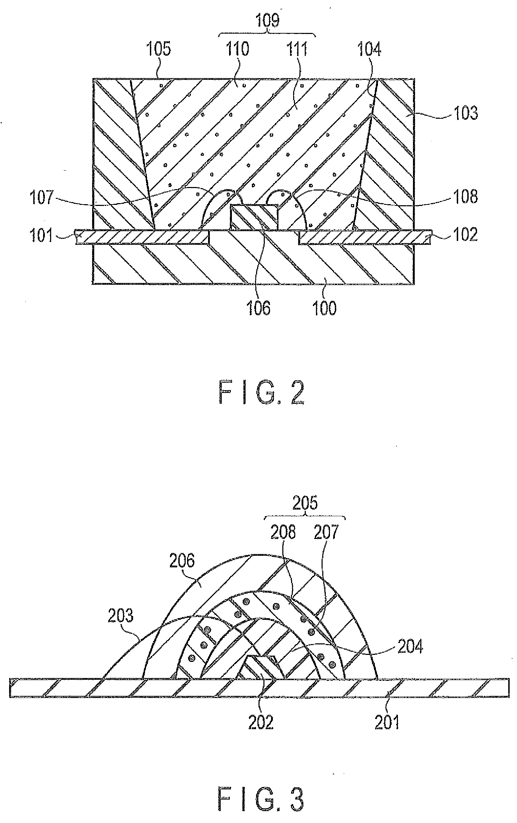

A light-emitting device according to one embodiment has a luminous layer including the phosphor described above, and a light source (light-emitting element) exciting the phosphor described above. FIG. 2 is a schematic view showing a structure of a light-emitting device according to one embodiment.

In the light-emitting device shown in FIG. 2, leads 101 and 102 and a package cup 103 are disposed on a substrate 100. The substrate 100 and the package cup 103 are made of a resin. The package cup 103 has a recess 105 whose upper part is larger than its bottom part, and a side surface of this depression part acts as a reflection surface 104.

A light-emitting element 106 is mounted at a center part of an almost circular bottom face of the recess 105 with an Ag paste, or the like. The light-emitting element 106 which can be used is an element capable of emitting light having an emission peak within a wavelength range of 400 to 500 nm. Such a light-emitting element may include, for example, a light-emitting diode, a laser diode, and the like. Specifically, it is exemplified by semiconductor GaN-type light-emitting elements, and the like, but it is not particularly limited.

A p-electrode and an n-electrode (not shown in the figure) of the light-emitting element 106 are respectively connected to the lead 101 and the lead 102 with a bonding wires 107 and 108 made of Au or the like. The arrangement of the leads 101 and 102 may be appropriately changed.

As the light-emitting element 106, a flip-chip light-emitting element having the n-electrode and the p-electrode on the same surface may be used. In this case, problems resulting from wires such as breaking or separation of wires, and light absorption by wires can be solved, and a semiconductor light-emitting device having high reliability and high brightness can be obtained. Using a light-emitting element having an n-type substrate, the following structure may be formed. An n-electrode is formed on a bottom surface of the n-type substrate of the light-emitting element, and a p-electrode is formed on a top surface of a p-type semiconductor layer laminated on the substrate. The n-electrode is mounted on a lead, and the p-electrode is connected to the other lead with a wire.

A luminous layer 109 including a phosphor 110 according to one embodiment is disposed in the recess 105 of the package cup 103. In the luminous layer 109, for example, 5 to 60% by mass of the phosphor 110 is included in a resin layer 111 of a silicone resin. As described above, the phosphor according to the present embodiment includes $Sr_2Al_3Si_7ON_{13}$ as the matrix, and such an oxynitride has a high covalency. For this reason, the phosphor according to the present embodiment is hydrophobic, and has a very good compatibility with a resin. Thus, scattering can be remarkably suppressed at an interface between the resin layer and the phosphor, and light extraction efficiency is improved.

The yellow-emitting phosphor according to the present embodiment can emit yellow light with high efficiency. A white light-emitting device having a good luminescence property can be obtained by combination with a light-emitting element capable of emitting light having an emission peak within a wavelength range of 400 to 500 nm.

A size and a kind of the light-emitting element 106, and dimensions and a shape of the recess 105 can be appropriately changed.

The light-emitting device according to one embodiment is not limited to the package cup-type device as shown in FIG. 2, and can be appropriately changed. Specifically, when the phosphor of the embodiment is applied to a shell-type LED or a surface-mounting LED, the same effects as above can be obtained.

FIG. 3 is a schematic view showing a structure of a light-emitting device according to another embodiment. In the light-emitting device shown in this figure, a p-electrode and an n-electrode (not shown in the figure) are formed on given areas of a heat-dissipating insulation substrate 201, and a light-emitting element 202 is disposed thereon. As the material of the heat-dissipating insulation substrate 201, for example, AlN may be used.

One electrode in the light-emitting element 202 is formed on the bottom face thereof, and is electrically connected to an n-electrode of the heat-dissipating insulation substrate 201. The other electrode in the light-emitting element 202 is connected to a p-electrode (not shown in the figure) on the heat-dissipating insulation substrate 201 through a gold wire 203. As the light-emitting element 202, a light-emitting diode capable of emitting light having an emission peak within a wavelength range of 400 to 500 nm is used.

A dome-shaped inside transparent resin layer 204, a luminous layer 205, and an outside transparent resin layer 206 are sequentially formed on the light-emitting element 202. The inside transparent resin layer 204 and the outside transparent resin layer 206 may be formed, for example, using silicone, or the like. In the luminous layer 205, for example, the yellow-emitting phosphor 207 of the present embodiment is contained in a resin layer 208 formed of, for example, a silicone resin.

In the light-emitting device shown in FIG. 3, the luminous layer 205 including the yellow-emitting phosphor according to the present embodiment can be conveniently produced employing a vacuum printing method or a drop coating method using a dispenser. Moreover, because the luminous layer 205 is put between the inside transparent resin layer 204 and the outside transparent resin layer 206, the effect to improve the extraction efficiency can be obtained.

The luminous layer in the light-emitting device according to the present embodiment may include a phosphor capable of emitting green light by excitation with blue light and a phosphor capable of emitting red light by excitation with blue light, together with the yellow-emitting phosphor of the present embodiment. In this case, a white light-emitting device having more excellent color rendering property can be obtained. A phosphor having a different luminescent color is included in a separate luminous layer, whereby a laminated structure can be produced in which a luminous layer including a yellow-emitting phosphor, a luminous layer including a green-emitting phosphor, and a luminous layer including a red-emitting phosphor are included.

Yellow emission can also be obtained when the yellow-emitting phosphor according to the present embodiment is excited with light with the ultraviolet region having a peak within a wavelength range of 250 to 430 nm. A white light-emitting device, therefore, can also be formed by combining the phosphor according to the present embodiment with, for example, a phosphor capable of emitting blue light (a peak wavelength: 400 to 490 nm) by excitation with ultraviolet light and a light-emitting element such as an ultraviolet light-emitting diode. The luminous layer in the white light-emitting device may include a phosphor capable of emitting light having a peak within another wavelength range by excitation with ultraviolet light together with the yellow-emitting phosphor of the present embodiment. Such a phosphor may include, for example, a phosphor capable of emitting red light by excitation with ultraviolet light, a phosphor capable of emitting green light by excitation with ultraviolet light, and the like.

As described above, the phosphor of the present embodiment can emit yellow light with high efficiency. When such a yellow-emitting phosphor of the present embodiment is combined with a light-emitting element capable of emitting light having an emission peak within a wavelength range of 250 to 500 nm, the white light-emitting device having an excellent luminescence property can be obtained using fewer kinds of the phosphors.

Specific examples of the phosphor and the light-emitting device are shown below.

First, $Sr_3N_2$, $CeCl_3$, $Si_3N_4$, AlN, and $B(OH)_3$ were prepared as a Sr source, a Ce source, a Si source, a Al source, and a B source, and each source was weighed in a glove box. Blending masses of $Sr_3N_2$, $CeCl_3$, $Si_3N_4$, AlN and $B(OH)_3$ were 2.902 g, 0.148 g, 5.262 g, 1.537 g and 0.004 g, respectively. The mixture powders were dry-mixed in an agate mortar.

The obtained mixture was put into a boron nitride crucible, and the mixture was fired at 1750°C for 15 hours in a nitrogen atmosphere having a pressure of 7.5 atmospheres, thereby obtaining a phosphor of Example 1.

The obtained phosphor was powder having a body color of yellow, and it was confirmed that the material emitted yellow light when it was excited with black light.

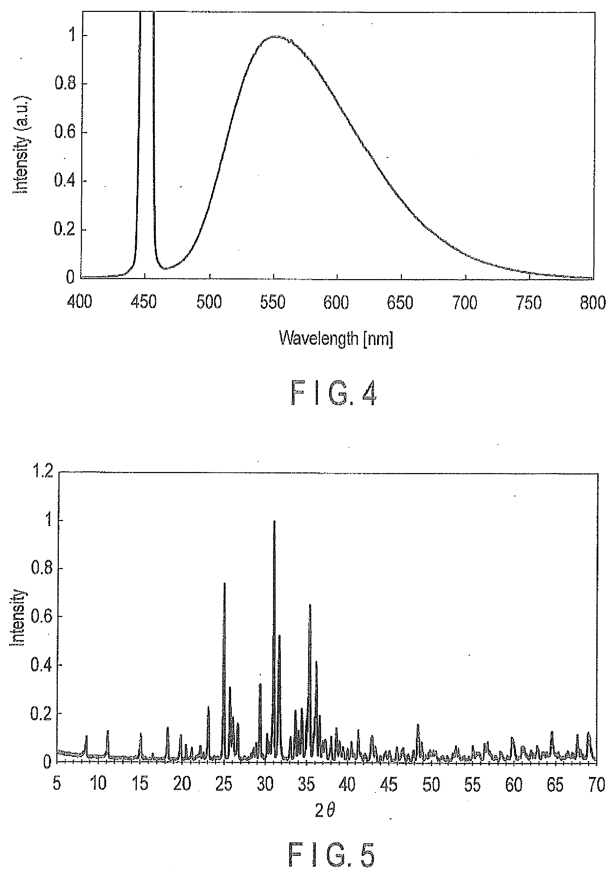

Emission spectra obtained by exciting this phosphor with a xenon lamp in which the light was spectrally dispersed into an emission wavelength of 450 nm are shown in FIG. 4. In FIG. 4, an emission having a narrow half-width at near 450 nm is reflection of excitation light, and is not emission of the phosphor. A high emission intensity was observed at a peak wavelength of 551 nm.

A light-emitting device having a structure shown in FIG. 3 was produced using the phosphor of the present Example.

An 8 mm square AlN substrate, on which a p-electrode and an n-electrode (not shown in the figure) were formed in predetermined area, was prepared as a heat-dissipating insulation substrate 201. A fight-emitting diode having an emission peak wavelength of 460 nm was joined to the substrate through a solder as a light-emitting element 202. One electrode of a light-emitting element 202 was formed on the bottom face thereof, and was electrically connected to the n-electrode of the AIN substrate 201. The other electrode of the light-emitting element 202 was connected to the p-electrode (not shown in the figure) on the AIN substrate 401 through a gold wire 403.

An inside transparent resin layer 204, a luminous layer 205, and an outside transparent resin layer 206 were sequentially formed in a dome-shape on the light-emitting element 202, thereby producing a light-emitting device of the present Example. A silicone resin was used as a material of the inside transparent resin layer 204, and the layer was formed using a dispenser. In order fo form the luminous layer 205, a transparent resin including 25% by mass of the phosphor of the present Example was used. The transparent resin used was a silicone resin. In addition, in order to form the outside transparent resin layer 206 on the luminous layer 205, the same silicone resin as used in the formation of the inside transparent resin layer 204 was used.

This light-emitting device was installed in an integrating sphere. When the device was driven at 20 mA and 3 V, the color temperature was 5000 K and Ra = 68. The color temperature and Ra were obtained from an instantaneous multichannel spectrometer.

A white light-emitting device of the present embodiment could be obtained by combining the phosphor of the present Example with a blue LED having an emission peak wavelength of 460 nm. A high power white LED having a high luminous efficiency can be obtained from such a white light-emitting device.

Further, phosphors of Examples 2 to 6 and Comparative Example were obtained in the same manner as in Example 1 except that the raw material, the blending mass thereof, and the calcination temperature were changed as shown in Table 2.

Table 2

| | Mass (g) | | | | | Heating Temperature (°C) |
|---|---|---|---|---|---|---|
| | $Sr_3N_2$ | $CeCl_2$ | $Si_3N_4$ | AIN | $B(OH)_3$ | |
| Example 1 | 2.902 | 0.148 | 5.262 | 1.537 | 0.004 | 1750 |
| Example 2 | 2.902 | 0.148 | 5.262 | 1.537 | 0.003 | 1700 |
| Example 3 | 2.887 | 0.185 | 5.402 | 1.414 | 0.003 | 1700 |
| Example 4 | 3.055 | 0.222 | 5.402 | 1.414 | 0.002 | 1800 |
| Example 5 | 2.887 | 0.185 | 5.402 | 1.414 | 0.006 | 1800 |
| Example 6 | 2.872 | 0.222 | 5.262 | 1.537 | 0.013 | 1800 |
| Comparative Example 1 | 2.887 | 0.185 | 5.402 | 1.414 | 0.023 | 1800 |

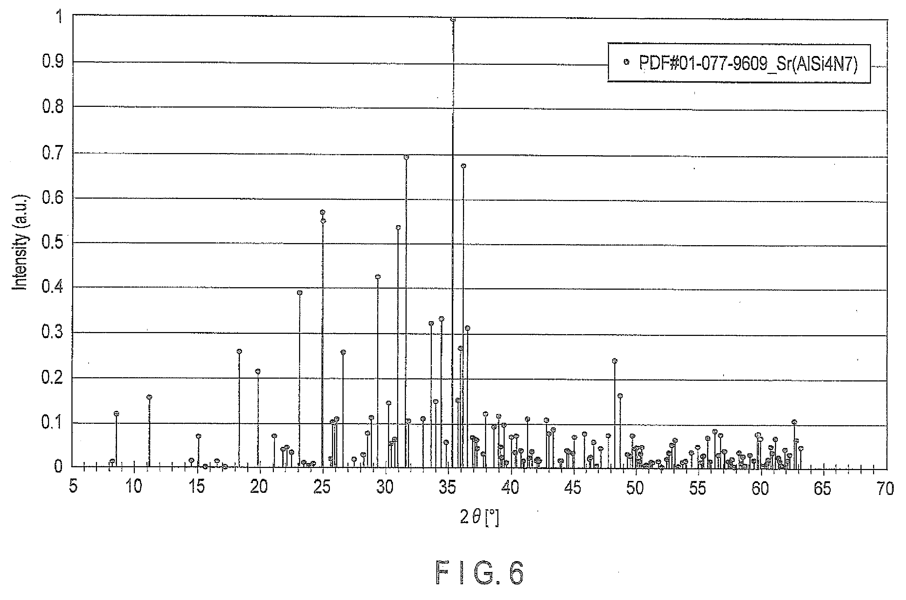

The phosphors of Examples 2 to 6 and Comparative Example were all powders having a body color of yellow, and it was confirmed that the materials emitted yellow light when they were excited with black light. Here, an XRD pattern of the phosphor from Example 4 is shown in FIG. 5 and a JCPDS card (No. 01-077-9609) is shown in FIG. 6. It can be seen that a desired phosphor is roughly formed in a single phase from the comparison of FIG. 5 with FIG. 6. XRD patterns of the phosphors of Examples 1 to 3, 5 and 6 were the same as that of the phosphor of Example 4. With respect to the XRD patterns of Examples 1, 2 and 4, angles of diffraction ($2\theta$) of peaks having a peak intensity of 0.1 or more, when a peak intensity of a main peak is considered to be 1, are shown in Tables 3 and 4. In the Tables, "-" shows that a peak strength is less than 0.1.

Table 3

| | Example 1 | Example 2 | Example 4 |
|---|---|---|---|
| | 8.6 | 8.58 | 8.6 |
| | 11.18 | 11.17 | 11.16 |
| | 15.08 | 15.11 | 15.14 |
| | 18.32 | 18.31 | 18.3 |
| | 19.86 | 19.83 | 19.88 |
| | 23.08 | 23.1 | 23.08 |
| | 24.93 | 24.91 | 24.95 |
| | 25.8 | 25.74 | 25.68 |
| | 26.05 | 26.02 | 26.06 |
| | 26.62 | 26.61 | 26.63 |
| | 28.88 | 28.87 | - |
| $2\theta[°]$ | 29.36 | 29.38 | 29.36 |
| | 30.32 | 30.3 | 30.27 |
| | 30.99 | 30.97 | 30.97 |
| | 31.68 | 31.69 | 31.68 |
| | 33.1 | 33.05 | 33.09 |
| | 33.67 | 33.64 | 33.67 |
| | 34.02 | 34.03 | 34.04 |
| | 34.44 | 34.41 | 34.46 |
| | 35.3 | 35.27 | 35.33 |
| | 36.19 | 36.15 | 36.13 |
| | 36.61 | 36.62 | 36.6 |
| | 37.34 | 37.34 | - |

Table 4

|  | Example 1 | Example 2 | Example 4 |
|---|---|---|---|
| 2θ[°] | - | - | 38.01 |
| | 38.68 | 38.65 | 38.64 |
| | 39.04 | - | - |
| | 39.51 | 39.49 | - |
| | 40.54 | 40.55 | - |
| | 41.32 | 41.29 | 41.34 |
| | 42.9 | 42.89 | - |
| | - | - | 43.04 |
| | 45.95 | 45.93 | - |
| | 48.37 | 48.37 | 48.43 |
| | 48.83 | 48.82 | - |
| | 49.83 | - | - |
| | 55.04 | - | - |
| | 56.77 | 56.69 | - |
| | 59.99 | 59.92 | 59.85 |
| | - | 60.98 | - |
| | 61.13 | - | - |
| | 62.05 | 62.11 | - |
| | 62.85 | 62.77 | - |
| | 64.59 | 64.53 | 64.53 |
| | 67.66 | 67.65 | 67.68 |
| | 68.96 | 68.98 | 68.95 |

As shown above, it was found that in the phosphor of any Example, the 10 strongest peaks belonged to any angle of diffraction (2θ) of 15.05 to 15.15°, 23.03 to 23.13°, 24.87 to 24.97°, 25.68 to 25.8°, 25.97 to 26.07°, 29.33 to 29.43°, 30.92 to 31.02°, 31.65 to 31.75°, 31.88 to 31.98°, 33.02 to 33.12°, 33.59 to 33.69°, 34.35 to 34.46°, 35.2 to 35.33°, 36.02 to 36.12°, 36.55 to 36.65°, 37.3 to 37.4°, and 56.5 to 56.6°.

Light-emitting devices were produced in the same manner as above except that the phosphors of Examples 2 to 6 were used, and the properties thereof were examined in the same manner as above. It was confirmed that these light-emitting devices had the same properties as those of the light-emitting device using the phosphor of Example 1.

Table 5 summarizes the results of a chemical analysis of the phosphors of Examples 1 to 6 and Comparative Example using inductively coupled plasma (ICP). Table 6 summarizes values of x, y, z, u, s and the like in the following Formula 1.

$$(M_{1-x}Ce_x)_{2y}Al_zSi_{10-z}O_uN_wP_S \qquad \text{Formula 1}$$

Table 5

|  | Sr | Ce | Al | Si | O | N | B |
|---|---|---|---|---|---|---|---|
| Example 1 | 1.88 | 0.04 | 2.70 | 7.30 | 0.46 | 13 | 0.046 |
| Example 2 | 1.91 | 0.04 | 2.65 | 7.35 | 0.60 | 14 | 0.031 |
| Example 3 | 1.83 | 0.05 | 2.44 | 7.56 | 0.59 | 13 | 0.028 |
| Example 4 | 1.82 | 0.06 | 2.50 | 7.50 | 0.41 | 13 | 0.023 |

(continued)

|  | Sr | Ce | Al | Si | O | N | B |
|---|---|---|---|---|---|---|---|
| Example 5 | 1.91 | 0.05 | 2.32 | 7.68 | 0.47 | 14 | 0.063 |
| Example 6 | 1.90 | 0.07 | 2.33 | 7.67 | 0.37 | 14 | 0.139 |
| Comparative Example 1 | 1.83 | 0.05 | 2.30 | 7.70 | 0.39 | 14 | 0.245 |

Table 6

| As shown in Table 6, all values of x, y, z, u, z - u, u + w, and s are within a range | | | | | | | |
|---|---|---|---|---|---|---|---|
|  | x | y | z | u | z-u | u+w | s |
| Example 1 | 0.02 | 0.96 | 2.70 | 0.46 | 2.24 | 13.47 | 0.046 |
| Example 2 | 0.02 | 0.97 | 2.65 | 0.60 | 2.05 | 14.10 | 0.031 |
| Example 3 | 0.03 | 0.94 | 2.44 | 0.59 | 1.85 | 13.65 | 0.028 |
| Example 4 | 0.03 | 0.94 | 2.50 | 0.41 | 2.09 | 13.68 | 0.023 |
| Example 5 | 0.03 | 0.98 | 2.32 | 0.47 | 1.85 | 14.15 | 0.063 |
| Example 6 | 0.03 | 0.98 | 2.33 | 0.37 | 1.97 | 13.97 | 0.139 |
| Comparative Example 1 | 0.03 | 0.94 | 2.30 | 0.39 | 1.91 | 13.96 | 0.245 |

shown below in the all phosphors of Examples 1 to 6. On the other hand, in the phosphor of Comparative Example, the value of s is 0.245, which is out of the range below.

$$0 < x \leq 1, 0.8 \leq y \leq 1.1, 2 \leq z \leq 3.5, 1 < u \leq 1$$

$$5 \leq z - u, 13 \leq u + w \leq 15, \text{ and } 0 < s < 0.245.$$

Quantum efficiencies of the phosphors of Examples 1 to 6 and Comparative Example were obtained according to a method described below. Specifically, a quantum efficiency was measured using (a fluorescence spectrophotometer (an absolute quantum yield measurement system C9920-02G) manufactured by Hamamatsu Photonics K.K.).

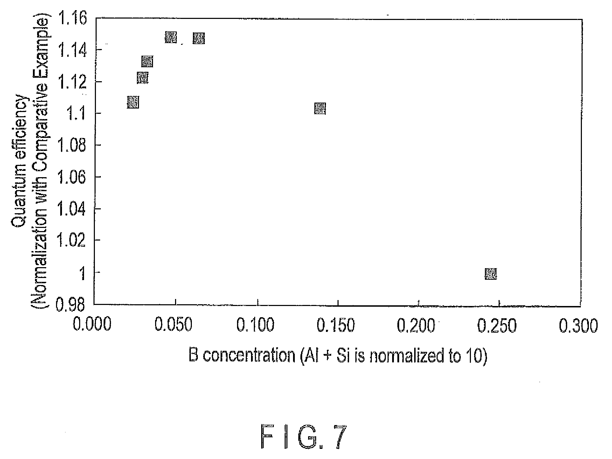

FIG. 7 is a graph in which relationships between a B concentration and a quantum efficiency in each phosphor are plotted. The B concentration here is a value obtained by normalization, supposing that a total of an Al concentration and an Si concentration corresponds to the value of s in the Formula 1. The quantum efficiency is a value obtained by normalization using the value of Comparative Example. It can be seen that when the normalized B concentration is within a range of (0 < s < 0.245), the good quantum efficiency is obtained, and when s is 0.023 to 0.139, a quantum efficiency of 1.1 or more can be obtained compared to a value when the quantum efficiency of Comparative Example is normalized as 1.

$$(M_{1-x}Ce_x)_{2y}Al_zSi_{10-z}O_uN_wB_S \qquad \text{Formula 1}$$

When the phosphors of Examples have the predetermined elements in the predetermined composition, particularly boron, the materials can emit yellow light with high efficiency. It was confirmed that even if a material includes the same elements, when the content of boron is out of the predetermined range, the high quantum efficiency cannot be obtained.

According to the embodiments of the present invention, the yellow-emitting phosphors having a high quantum efficiency and capable of obtaining a white LED illumination with high efficiency are provided. When the yellow-emitting phosphor of the present embodiment is combined with a blue LED, the white light-emitting device having a high efficiency can be obtained.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the scope of the inventions as defined by the appended claims.

**Claims**

1. A phosphor which exhibits a luminescence peak within a wavelength range of 500 to 600 nm when it is excited with light having an emission peak within a wavelength range of 250 to 500 nm, **characterized by** comprising a composition represented by Formula 1 below:

$$(M_{1-x}Ce_x)_{2y}Al_zSi_{10-z}O_uN_wB_S \qquad \text{Formula 1}$$

wherein M represents Sr and a part of Sr may be substituted by at least one selected from the group consisting of Ba, Ca and Mg; and x, y, z, u, w and s satisfy the following conditions:

$$0 < x \leq 1, 0.8 \leq y \leq 1.1, 2 \leq z \leq 3.5, 0 < u \leq 1$$

$$1.5 \leq z - u, 13 \leq u + w \leq 15, \text{ and } 0.02 \leq s \leq 0.14.$$

2. The phosphor according to claim 1, **characterized in that** the x satisfies $0.001 \leq x \leq 0.5$.

3. The phosphor according to claim 1, **characterized in that** the y satisfies $0.85 \leq y \leq 1.06$.

4. The phosphor according to claim 1, **characterized in that** the z satisfies $2.5 \leq z \leq 3.3$.

5. The phosphor according to claim 1, **characterized in that** the u satisfies $0.001 \leq u \leq 0.8$.

6. The phosphor according to claim 1, **characterized in that** the z - u satisfies $2 \leq z - u$.

7. The phosphor according to claim 1, **characterized in that** the u + w satisfies $13.2 \leq u + w \leq 14.2$.

8. The phosphor according to claim 1, **characterized in that** the phosphor has at least ten peaks at angles of diffraction ($2\theta$) of 15.05 to 15.15°, 23.03 to 23.13°, 24.87 to 24.97°, 25.68 to 25.8°, 25.97 to 26.07°, 29.33 to 29.43°, 30.92 to 31.02°, 31.65 to 31.75°, 31.88 to 31.98°, 33.02 to 33.12°, 33.59 to 33.69°, 34.35 to 34.46°, 35.2 to 35.33°, 36.02 to 36.12°, 36.55 to 36.65°, 37.3 to 37.4°, and 56.5 to 56.6°, in an X-ray diffraction by Bragg-Brendano method using a Cu-K$\alpha$ line.

9. A light-emitting device **characterized by** comprising:

   a light source which emits light having an emission peak in a wavelength range of 250 to 500 nm; and
   a luminous layer comprising a yellow-emitting phosphor comprising the phosphor of any one of claims 1 to 8.

10. The light-emitting device according to claim 9, **characterized by** further comprising a heat-dissipating insulation substrate on which the light source is disposed.

11. The light-emitting device according to claim 9, **characterized in that** the luminous layer further comprises a green-emitting phosphor and a red-emitting phosphor.

12. The light-emitting device according to claim 11, **characterized in that** the luminous layer has a three-layer laminated structure, and each of the yellow-emitting phosphor, the green-emitting phosphor and the red-emitting phosphor being comprised in individual separate luminous layer.

13. The light-emitting device according to claim 9, **characterized in that** the light source emits light having a wavelength of 250 to 430 nm.

14. The light-emitting device according to claim 13, **characterized in that** the luminous layer further comprises a phosphor which exhibits a luminescence peak within a wavelength range of 400 to 490 nm when excited by the light from the light source.


**Patentansprüche**

1. Leuchtstoff, der einen Lumineszenzpeak innerhalb eines Wellenlängenbereichs von 500 bis 600 nm aufweist, wenn er mit Licht, das einen Emissionspeak innerhalb eines Wellenlängenbereichs von 250 bis 500 nm aufweist, angeregt wird, **dadurch gekennzeichnet, dass** er eine Zusammensetzung umfasst, die durch Formel 1 unten dargestellt wird:

$$(M_{1-x}Ce_x)_{2y}Al_zSi_{10-z}O_uN_wB_S \qquad \text{Formel 1}$$

worin M Sr darstellt und ein Teil des Sr durch zumindest eines, das aus der Gruppe ausgewählt ist, bestehend aus Ba, Ca und Mg, ersetzt sein kann; und x, y, z, u, w und s die folgenden Bedingungen erfüllen:

$$0 < x \leq 1, \ 0{,}8 \leq y \leq 1{,}1, \ 2 \leq z \leq 3{,}5, \ 0 < u \leq 1$$

$$1{,}5 \leq z - u, \ 13 \leq u + w \leq 15 \ \text{und} \ 0{,}02 \leq s \leq 0{,}14.$$

2. Leuchtstoff gemäß Anspruch 1, **dadurch gekennzeichnet, dass** x $0{,}001 \leq x \leq 0{,}5$ erfüllt.

3. Leuchtstoff gemäß Anspruch 1, **dadurch gekennzeichnet, dass** y $0{,}85 \leq y \leq 1{,}06$ erfüllt.

4. Leuchtstoff gemäß Anspruch 1, **dadurch gekennzeichnet, dass** z $2{,}5 \leq z \leq 3{,}3$ erfüllt.

5. Leuchtstoff gemäß Anspruch 1, **dadurch gekennzeichnet, dass** u $0{,}001 \leq u \leq 0{,}8$ erfüllt.

6. Leuchtstoff gemäß Anspruch 1, **dadurch gekennzeichnet, dass** z - u $2 \leq z - u$ erfüllt.

7. Leuchtstoff gemäß Anspruch 1, **dadurch gekennzeichnet, dass** u + w $13{,}2 \leq u + w \leq 14{,}2$ erfüllt.

8. Leuchtstoff gemäß Anspruch 1, **dadurch gekennzeichnet, dass** der Leuchtstoff zumindest zehn Peaks bei Beugungswinkeln ($2\theta$) von 15,05 bis 15,15°, 23,03 bis 23,13°, 24,87 bis 24,97°, 25,68 bis 25,8°, 25,97 bis 26,07°, 29,33 bis 29,43°, 30,92 bis 31,02°, 31,65 bis 31,75°, 31,88 bis 31,98°, 33,02 bis 33,12°, 33,59 bis 33,69°, 34,35 bis 34,46°, 35,2 bis 35,33°, 36,02 bis 36,12°, 36,55 bis 36,65°, 37,3 bis 37,4° und 56,5 bis 56,6° in einem Röntgenbeugungsverfahren nach Bragg-Brendano unter Verwendung der Cu-K$\alpha$-Linie aufweist.

9. Lichtemittierende Vorrichtung, **dadurch gekennzeichnet, dass** sie umfasst:

   eine Lichtquelle, die Licht, das einen Emissionspeak in einem Wellenlängenbereich von 250 bis 500 nm aufweist, emittiert; und
   eine Leuchtschicht, die einen gelb emittierenden Leuchtstoff umfasst, der den Leuchtstoff gemäß einem beliebigen der Ansprüche 1 bis 8 umfasst.

10. Lichtemittierende Vorrichtung gemäß Anspruch 9, **dadurch gekennzeichnet, dass** sie ferner ein Wärme-ableitendes Isolationssubstrat, auf dem die Lichtquelle angeordnet ist, umfasst.

11. Lichtemittierende Vorrichtung gemäß Anspruch 9, **dadurch gekennzeichnet, dass** die Leuchtschicht ferner einen grün emittierenden Leuchtstoff und einen rot emittierenden Leuchtstoff umfasst.

12. Lichtemittierende Vorrichtung gemäß Anspruch 11, **dadurch gekennzeichnet, dass** die Leuchtschicht eine laminierte Struktur aus drei Schichten aufweist und jeder des gelb emittierenden Leuchtstoffs, des grün emittierenden Leuchtstoffs und des rot emittierenden Leuchtstoffs in individuellen separaten Leuchtschichten enthalten ist.

13. Lichtemittierende Vorrichtung gemäß Anspruch 9, **dadurch gekennzeichnet, dass** die Lichtquelle Licht, das eine Wellenlänge von 250 bis 430 nm aufweist, emittiert.

14. Lichtemittierende Vorrichtung gemäß Anspruch 13, **dadurch gekennzeichnet, dass** die Leuchtschicht ferner einen Leuchtstoff umfasst, der einen Lumineszenzpeak innerhalb eines Wellenlängenbereichs von 400 bis 490 nm aufweist, wenn er durch das Licht von der Lichtquelle angeregt wird.

**Revendications**

1. Luminophore présentant une crête de luminescence dans une plage de longueurs d'onde allant de 500 à 600 nm lorsqu'il est excité avec de la lumière ayant une crête d'émission dans une plage de longueurs d'onde allant de 250 à 500 nm, **caractérisé en ce qu'**il comprend une composition représentée par la formule 1 ci-dessous :

$$(M_{1-x}Ce_x)_{2y}Al_zSi_{10-z}O_uN_wB_S \qquad \text{Formule 1}$$

dans laquelle M représente Sr et une partie de Sr peut être remplacée par au moins un élément choisi dans le groupe constitué de Ba, Ca et Mg ; et x, y, z, u, w et s satisfont aux conditions suivantes :

$$0 < x \le 1,\ 0{,}8 \le y\ 1{,}1,\ 2 \le z \le 3{,}5,\ 0 < u \le 1$$

$$1{,}5 \le z\text{-}u,\ 13 \le u+w \le 15 \text{ et } 0{,}02 \le s \le 0{,}14.$$

2. Luminophore selon la revendication 1, **caractérisé en ce que** x satisfait à $0{,}001 \le x \le 0{,}5$.

3. Luminophore selon la revendication 1, **caractérisé en ce que** y satisfait à $0{,}85 \le y \le 1{,}06$.

4. Luminophore selon la revendication 1, **caractérisé en ce que** z satisfait à $2{,}5 \le z \le 3{,}3$.

5. Luminophore selon la revendication 1, **caractérisé en ce que** u satisfait à $0{,}001 \le u \le 0{,}8$.

6. Luminophore selon la revendication 1, **caractérisé en ce que** z-u satisfait à $2 \le z\text{-}u$.

7. Luminophore selon la revendication 1, **caractérisé en ce que** u+w satisfait à $13{,}2 \le u+w \le 14{,}2$.

8. Luminophore selon la revendication 1, **caractérisé en ce que** le luminophore comporte au moins dix crêtes avec des angles de diffraction $(2\theta)$ de 15,05 à 15,15°, 23,03 à 23,13°, 24,87 à 24,97°, 25,68 à 25,8°, 25,97 à 26,07°, 29,33 à 29,43°, 30,92 à 31,02°, 31,65 à 31,75°, 31,88 à 31,98°, 33,02 à 33,12°, 33,59 à 33,69°, 34,35 à 34,46°, 35,2 à 35,33°, 36,02 à 36,12°, 36,55 à 36,65°, 37,3 à 37,4° et 56,5 à 56,6°, dans une diffraction par rayons X par le procédé de Bragg-Brendano utilisant une ligne Cu-Ka.

9. Dispositif émetteur de lumière **caractérisé en ce qu'**il comprend :

une source de lumière qui émet de la lumière ayant une crête d'émission dans la plage de longueurs d'onde allant de 250 à 500 nm ; et
une couche lumineuse comprenant un luminophore émettant du jaune comprenant le luminophore selon l'une quelconque des revendications 1 à 8.

10. Dispositif émetteur de lumière selon la revendication 9, **caractérisé en ce qu'**il comprend en outre un substrat d'isolation dissipant la chaleur sur lequel est disposée la source de lumière.

**11.** Dispositif émetteur de lumière selon la revendication 9, **caractérisé en ce que** la couche lumineuse comprend en outre un luminophore émettant du vert et un luminophore émettant du rouge.

**12.** Dispositif émetteur de lumière selon la revendication 11, **caractérisé en ce que** la couche lumineuse possède une structure stratifiée à trois couches, et chacun du luminophore émettant du jaune, du luminophore émettant du vert et du luminophore émettant du rouge est constitué dans une couche lumineuse séparée individuelle.

**13.** Dispositif émetteur de lumière selon la revendication 9, **caractérisé en ce que** la source de lumière émet de la lumière ayant une longueur d'onde allant de 250 à 430 nm.

**14.** Dispositif émetteur de lumière selon la revendication 13, **caractérisé en ce que** la couche lumineuse comprend en outre un luminophore présentant une crête de luminescence dans la plage de longueurs d'onde allant de 400 à 490 nm, lorsqu'il est excité par de la lumière provenant de la source de lumière.

F I G. 1A

F I G. 1B

FIG. 1C

FIG. 2

FIG. 3

FIG. 4

FIG. 5

F I G. 6

EP 2 803 716 B1

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2012104317 A1

**Non-patent literature cited in the description**

- International Tables for Crystallography, Volume A: Space-group symmetry. Springer, 1983